Europäisches Patentamt

European Patent Office

Office européen des brevets

(11) Numéro de publication: **0 035 416**
A2

# DEMANDE DE BREVET EUROPEEN

(21) Numéro de dépôt: **81400110.3**

(22) Date de dépôt: **27.01.81**

(51) Int. Cl.³: **H 01 L 21/90,** H 01 L 21/60, H 01 L 21/263, H 01 L 21/306 // H01L21/31

(30) Priorité: **22.02.80 FR 8003974**

(43) Date de publication de la demande: **09.09.81** **Bulletin 81/36**

(84) Etats contractants désignés: **DE GB NL**

(71) Demandeur: **THOMSON-CSF, 173, Boulevard Haussmann, F-75360 Paris Cedex 08 (FR)**

(72) Inventeur: **Cornette, André, THOMSON-CSF SCPI 173, Bld Haussmann, F-75360 Paris Cedex 08 (FR)**
Inventeur: **Rey, Georges, THOMSON-CSF SCPI 173, Bld Haussmann, F-75360 Paris Cedex 08 (FR)**

(74) Mandataire: **Giraud, Pierre et al, "THOMSON-CSF" - SCPI 173, bld Haussmann, F-75360 Paris Cedex 08 (FR)**

(54) **Procédé d'isolement des interconnexions de circuits intégrés, et circuit intégré utilisant ce procédé.**

(57) L'invention concerne les circuits intégrés dont chaque composant est réalisé dans une couche active, supporté par un îlot, dit mésa, du substrat.

En vue de constituer une couche diélectrique (10) en surface du substrat et sur les flancs des mésas (1), les composants sont protégés par une couche métallique (8), puis les mésas sont creusés ave légère sous-gravure (12) sous la couche métallique. Le diélectrique (11) est déposé sur toute la surface du circuit, par pulvérisation cathodique, ce qui permet d'épargner la partie de la couche métallique dans son pourtour sous-gravé. Une attaque chimique, à partir de la sous-gravure, élimine la couche métallique et le diélectrique qu'elle supporte (8 + 11).

Applications aux circuits intégrés rapides, dont les composants de très petites dimensions sont réalisés dans des semiconducteurs de type III–V, II–VI.

0035416

PROCEDE D'ISOLEMENT DES INTERCONNEXIONS DE
CIRCUITS INTEGRES, ET CIRCUIT INTEGRE UTILISANT CE
PROCEDE.

L'invention concerne un procédé d'isolement des interconnexions de circuits intégrés dont les composants actifs constituent des îlots en relief appelés mésas à la surface du substrat. La présente invention s'applique plus particulièrement aux circuits intégrés rapides réalisés sur des matériaux semiconducteurs de type 3 et 5, 2 et 6 ... etc, c'est-à-dire ceux qui sont des types GaAs, Al Ga As,... En effet, dans ces circuits intégrés, une couche active est réalisée sur un substrat semi-isolant, et chaque composant réalisé sur un mésa qui se présente comme un îlot en relief par rapport au substrat qui constitue le support mécanique du circuit intégré. Cette structure provient du fait que la réalisation de structures "planar" n'est pas possible avec les techniques actuellement connues.

Dans le cas le plus courant de GaAs ou de ses dérivés, l'arsénic migre et se volatilise à haute température, supérieure à 800° C. Or, la diffusion d'un caisson isolant autour d'un transistor planar par exemple passe par une étape à haute température, et l'implantation ionique détruit le réseau cristallin en surface qu'il faut alors réorganiser par un recuit, à haute température également. C'est pourquoi, dans l'état actuel des techniques, les circuits intégrés des types 3-5, 2-6 sont réalisés par les techniques mésas. La réalisation de ces mésas, c'est-à-dire d'un îlot pour chacun des composants, présente de grandes difficultés liées aux dimensions extrêmement petites des îlots en question qui sont de l'ordre du micromètre.

2.

L'invention s'applique également aux semiconducteurs sur silicium, mais alors elle est surtout intéressante dans le cas de composés discrets à structure mésa du type des transistors de puissance, thyristors, triacs ... etc qui nécessitent une passivation sur leurs contours, en raison du champ électrique de fuite. Pour réaliser des structures isolantes ou passivées, la méthode connue consiste à :

    - déposer une couche isolante sur la surface libre de la pastille semiconductrice -on entend par surface libre de la pastille celle qui n'est pas soudée sur l'embase du boîtier d'encapsulation- ;

    - déposer ensuite une résine photosensible sur la surface du semiconducteur en cours de fabrication ;

    - soumettre la résine à l'action des photons ou des électrons à travers un masque qui définit les parties de résine qui doivent être ôtées par la suite ;

    - ôter enfin l'isolant là où il ne doit pas subsister, par exemple à la surface des composants actifs, par un procédé de gravure chimique qui est fonction de la nature de la résine utilisée selon qu'elle est positive ou négative.

    Ce procédé connu qui vient d'être très rapidement décrit convient en fait pour des semiconducteurs dont les dimensions sont de l'ordre du millimètre, tels que par exemple des pastilles de transistors discrets ou de puissance. Cette technologie ne permet pas de réaliser des circuits intégrés très rapides, tels que ceux réalisés sur arséniure de gallium ou ses dérivés. La différence qui intervient réside essentiellement dans les dimensions des isolants à réaliser. Les substrats du type arséniure de gallium sont utilisés pour réaliser des circuits très rapides dont les éléments actifs tels que transistors, transistors à effet de champ, MOS, sont de toutes petites dimensions, de l'ordre du micron comme il a été dit : dans ces conditions, réaliser une passivation autour d'un mésa ne peut faire appel aux technologies connues car la longueur d'onde de la lumière visible ou même ultraviolette et la précision des masques obtenus n'est plus suffisante pour délimiter parfaitement les zones protégées ou isolées.

De plus, la réalisation d'une passivation sur un semiconducteur discret ou un circuit intégré classique sur silicium, nécessite au moins un masque supplémentaire : la réalisation de l'isolement des mésas selon l'invention ne fait appel qu'à un seul masque qui existe déjà puisqu'il a servi précédemment en cours de fabrication à la définition d'une étape dans la réalisation du circuit intégré. C'est donc un procédé qui, en fin de compte, ne nécessite aucun masque supplémentaire.

Pour réaliser des circuits intégrés à haute densité d'intégration ou à très grande vitesse, on fait appel non plus à un procédé photographique de masquage mais à un masqueur électronique et à des résines électro-sensibles, de préférence positives. Le masquage électronique apporte la précision désirée mais son emploi rationnel nécessite de n'exposer aux faisceaux du masqueur que le moins possible de résine de façon à opérer plus rapidement. Les résines positives permettent d'obtenir des traits dont la largeur est inférieure à 1 micron, par une technique de dépôt sur résine couramment appelée par le terme anglo-saxon "lift-off", technique qui sera exposée ultérieurement en détail de façon à faciliter la compréhension de l'invention.

Le procédé selon l'invention ne nécessite donc pas de masques autres que ceux existants pour réaliser le semiconducteur. Selon ce procédé, le semiconducteur est dans un premier temps protégé en surface par une couche métallique, puis un sillon mésa est réalisé autour de lui soit par usinage mécanique au moyen d'un bombardement ionique, soit par une voie chimique. Une étape importante du procédé selon l'invention, consiste à effectuer une légère sous-gravure par rapport au couvercle métallique qui protège le composant, sous-gravure à la fois de la couche active et du substrat : cette opération permettra ultérieurement d'attaquer chimiquement le couvercle métallique pour dégager et libérer le composant à la fin du procédé de fabrication. Enfin, l'ensemble de la pastille est recouvert d'un diélectrique à basse température et le composant actif qui se trouve donc "caché" sous un couvercle métallique lui-même recouvert par une couche de diélectrique est dégagé par attaque chimique. A la fin des opérations il reste donc un composant isolé sur un mésa et entouré par une couche de diélectrique qui recouvre le substrat sur toutes les parties situées entre les mésas à la surface du circuit intégré.

De façon plus précise, l'invention est constituée par un procédé d'isolement des interconnexions de circuits intégrés, dont les composants sont réalisés dans une couche active, sur des ilôts dénommés "mésa", en relief par rapport au substrat qui supporte la couche active, caractérisé en ce que, pour chaque composant, il comporte la suite des opérations suivantes :

- le composant est protégé sur sa surface libre par un dépôt métallique, constitué par une ou plusieurs couches de métaux de nature différente, et délimité par photolithographie ou par la méthode de dépôt sur résine ;

- le mésa est creusé autour du composant, par usinage ionique ;

- le substrat et la couche active, sous le dépôt métallique, sont attaqués en pourtour du mésa, par voie chimique, de façon à créer une sous-gravure du dépôt métallique ;

- un diélectrique est déposé, par pulvérisation cathodique à basse température, sur l'ensemble du circuit, le pourtour inférieur du dépôt métallique, sous-gravé au cours de l'opération précédente, étant épargné par cette méthode de pulvérisation ;

- le dépôt de diélectrique et le dépôt métallique qui recouvrent chaque composant, sont éliminés par attaque chimique du métal, ladite attaque commençant par le pourtour du dépôt métallique laissé à nu, tandis que le dépôt de diélectrique sur le substrat demeure et protège les flancs du mésa.

L'invention sera mieux comprise par la description qui va en être faite, laquelle s'appuie sur des figures qui représentent :

- figure 1 : le procédé de dépôt sur résine, ou "lift-off" ;

- figures 2 à 6 : les différentes étapes du procédé selon un premier processus de réalisation ;

- figures 7 à 9 : les étapes finales du procédé selon l'invention, dans une variante de réalisation.

Avant de donner la description de l'invention, le rappel de la méthode de dépôt de diélectrique sur résine, couramment appelé "lift-off", permettra de mieux comprendre les différentes phases de l'invention.

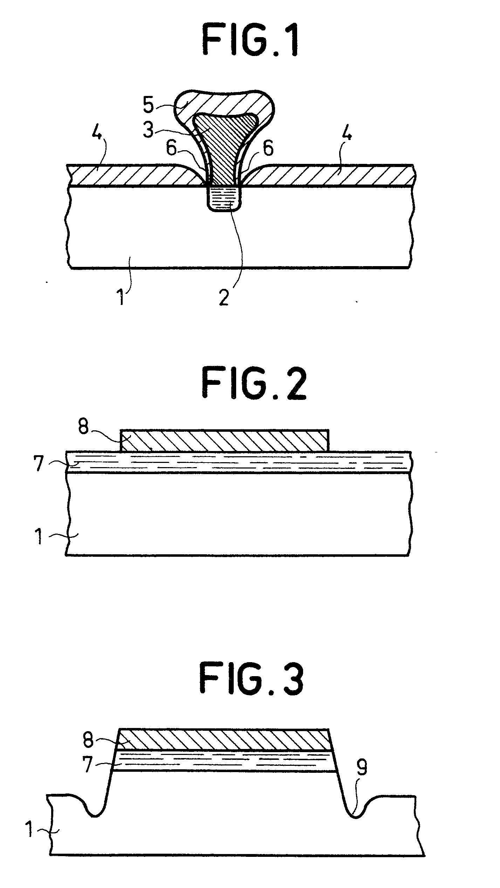

La figure 1 représente, vu en coupe, un substrat 1 dans lequel ou sur lequel doit être faite une opération dans une région 2 très petite. Cette opération peut être une diffusion dans l'épaisseur du substrat, ou peut également être un dépôt de métallisation ou d'isolant à la surface de la région 2 du substrat. Le procédé de "lift-off" comporte d'abord le dépôt d'une couche de résine sur la totalité du substrat, puis cette résine est gravée par photo-masquage et dissolution de telle sorte qu'il ne reste qu'une partie en forme de champignon 3 qui se trouve à l'aplomb de la région 2 sur laquelle on veut faire une opération. Dans la réalité des faits, la dissolution de la résine fait que le pion de résine 3 qui reste au-dessus de la région 2 n'est pas un parallélépipède, qu'il est légèrement dissous sur ses côtés ce qui lui donne un aspect de champignon.

Lorsque les différents pions 3 ont été réservés, l'ensemble du substrat est recouvert de couches de diélectriques, couche 4 sur le substrat et 5 sur le champignon de résine. Pour dégager la région 2, le champignon de résine est alors soumis à l'action combinée d'un solvant qui dissous la résine et des ultra-sons qui cassent la pellicule 6 de diélectrique au pied du champignon 3, pellicule qui va en s'amincissant et qui est de ce fait extrêmement fragile et perméable. Ainsi, lorsque le champignon de résine 3 a été dissous et que son enveloppe de diélectrique a été brisée, il ne reste à la surface du substrat 1 que des traces extrêmement petites mais très précises qui correspondent aux opérations que l'on veut faire dans une région 2.

Le procédé "lift-off" est utilisé au cours de l'invention comme cela va être décrit dans la figure suivante.

La figure 2 représente, vu en coupe, un substrat 1 semi-isolant sur lequel a été réalisée une couche 7 conductrice ou semiconductrice d'un type correspondant aux composants ou circuits intégrés que l'on doit réaliser à la surface du substrat 1. Un couvercle métallique 8 est déposé par métallisation sous vide puis gravure, sur la couche 7, la délimitation de chaque couvercle 8 correspondant à chacun des composants ou à chacune des parties constituantes du circuit intégré en cours de réalisation sur le substrat 1. A titre indicatif, la couche métallique 8 a une épaisseur de 800 nanomètres et elle est constituée par un dépôt d'aluminium délimité par photolithographie ou "lift-off".

La figure 3 représente la seconde étape du procédé.

Le mésa sur lequel doit être isolé le composant de la couche 7 est usiné par érosion mécanique par un usineur ionique, appelé en anglais "ion milling", qui soumet la couche active et la couche du substrat à un bombardement par des ions d'argon et par des électrons. Il est connu qu'au cours de cet usinage mécanique par des atomes, les flancs du mésa ont une légère pente et le mésa est entouré à sa base par l'équivalent d'un fossé 9.

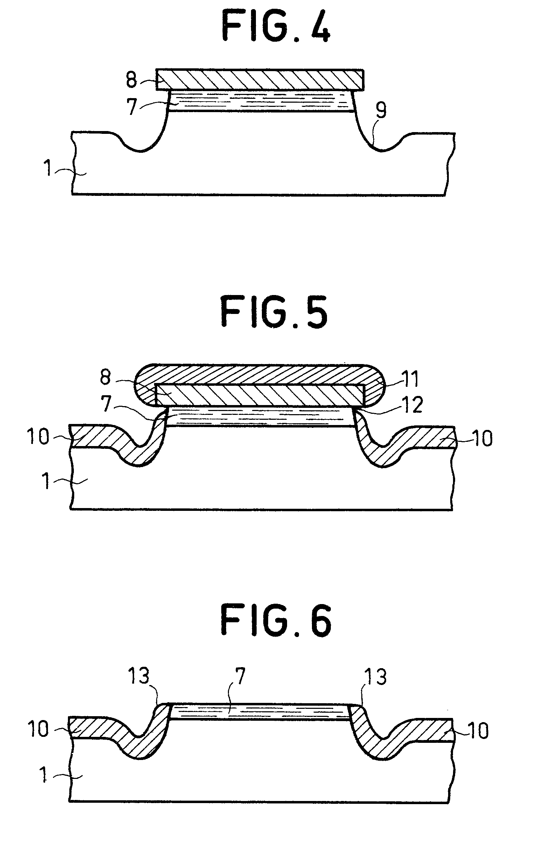

La figure 4 montre le résultat obtenu au cours de l'étape suivante par une sous-gravure du support semi-isolant ou semiconducteur sous le couvercle d'aluminium. Cette sous-gravure est obtenue par une érosion chimique, à partir d'une solution comportant, en ce qui concerne l'attaque de l'arséniure de gallium, une partie d'acide phosphorique $PO_4H_3$, une partie d'eau oxygénée $H_2O_2$ et 998 parties d'eau $H_2O$.

L'ensemble des étapes de la figure 3 et de la figure 4 peut être également remplacé par une unique étape de gravure du mésa -équivalente de ce qui est représenté figure 3- et de sous-gravure du mésa -équivalent de ce qui est représenté figure 4- par une unique érosion par voie chimique. Dans ce cas, le mésa n'est pas entouré par un fossé 9 mais décroît lentement jusqu'à la surface du substrat qui demeure après attaque chimique.

La figure 5 met en évidence que l'ensemble du substrat, qui comporte désormais un certain nombre de mésas recouverts chacun par un couvercle d'aluminium 8, est soumis à un dépôt de diélectrique à basse température sur toute la surface. Le dépôt de dioxide de silicium $SiO_2$ par exemple, a lieu par pulvérisation cathodique et a une épaisseur de l'ordre de 200 à 400 nanomètres. Le résultat obtenu est donc constitué par une couche 10 de diélectrique qui est déposé sur le substrat 1 autour des mésas et qui remonte le long des
flancs des mésas ; il est également constitué par une
couche 11 qui recouvre le couvercle d'aluminium 8 sur
chaque mésa.

L'opération de sous-gravure du mésa sous le couvercle d'aluminium trouve sa raison d'être en ce que
c'est la partie 12 de l'aluminium qui déborde légèrement du plateau du mésa qui va permettre l'attaque chimique par le pourtour de ce couvercle d'aluminium de
façon à en dégager le mésa.

La figure 6 représente le résultat obtenu à la
fin des opérations. Sur un substrat semi-isolant 1 se
trouve une plaquette d'un matériau semiconducteur 7 qui
est isolé par un mésa, dont les flancs sont également
protégés par une couche de diélectrique en 13, tandis
que cette même couche recouvre le substrat semi-isolant
en 10, l'aluminium et le diélectrique 11 qui se trouvaient par dessus le mésa ont disparu par attaque
chimique.

Dans le procédé de réalisation de l'invention tel
qu'il a été décrit, il est remarquable que sur les
flancs du mésa la couche de diélectrique vient araser
en 13 la face supérieure du mésa. Ceci est favorable
au fonctionnement par exemple des transistors à effet
de champ. Cependant, le cas où cette couche de diélectrique viendrait recouvrir légèrement les bords de la
face supérieure du mésa, formant en quelque sorte une
vague déposée sur le pourtour du composant 7, peut être
favorable à certains composants tels que des diodes.

Une variante du procédé de réalisation de l'invention permet de réaliser cette forme recouvrante
en vague. Seules en sont exposées les étapes ultérieures,
dans les trois figures suivantes.

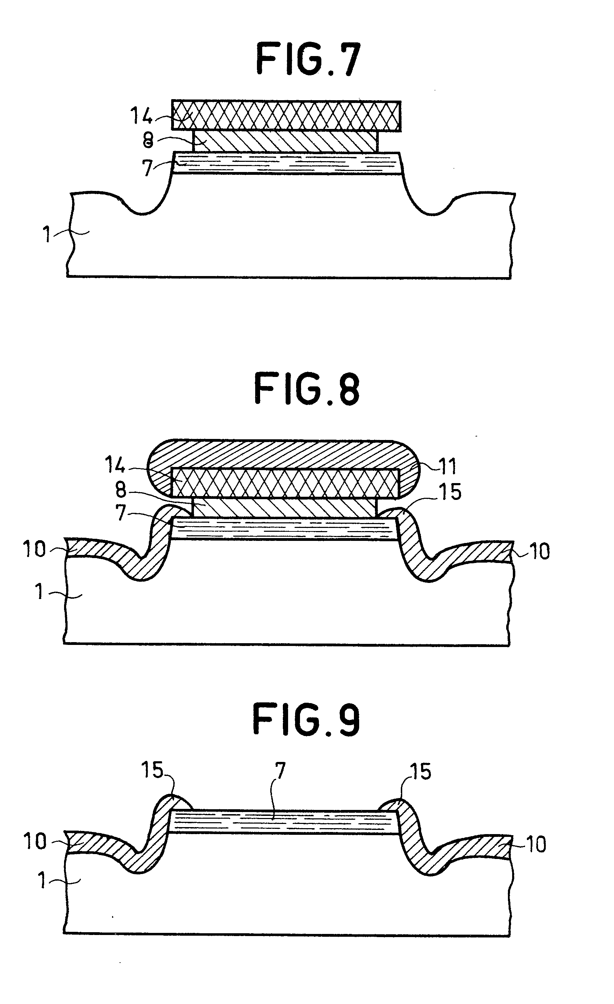

La figure 7 correspond à la figure 4 de la première
variante de l'invention, mais il est à noter que la couche active 7 a été recouverte d'abord d'une première
couche d'aluminium 8 puis d'une deuxième couche, de
chrome 14. Après que le mésa ait été usiné, l'aluminium est soumis à une légère sous-gravure par voie chimique : ainsi se crée entre la couche active 7 et
la couche de chrome 14 un retrait de l'aluminium dont
les dimensions sont restreintes par conséquence de
l'attaque chimique.

La figure 8 qui correspond à la figure 5 de la
première variante montre que lorsque la plaquette de
substrat est soumise à un dépôt de diélectrique à basse température, par pulvérisation cathodique, le diélectrique pénètre entre la couche active 7 et la couche de chrome 14 et forme cette vague légèrement enveloppante 15 dont il a été question.

La figure 9 montre le mésa en fin de fabrication
lorsque le triple couvercle d'aluminium, chrome et diélectrique a été ôté par attaque chimique. Le composant
actif 7 se trouve protégé sur tout son pourtour par le
diélectrique qui forme une vague enveloppante en 15 ;
les étapes suivantes de fabrication du circuit intégré ou
de la diode ont alors lieu par des procédés connus tels
que dépôt de couche de contact, métallisation etc ...

L'invention a été décrite en s'appuyant, pour clarifier le langage sur l'exemple d'un circuit intégré
réalisé sur arséniure de gallium; toutefois, il est bien
entendu que ce procédé de dépôt d'un diélectrique à la
surface d'un substrat s'applique beaucoup plus généralement à tous les semiconducteurs sur différents types
de substrats semiconducteurs dont les dimensions justifient d'avoir recours au procédé de "lift-off" plutôt
qu'au procédé classique qui s'applique à des semiconducteurs de plus grandes dimensions. A titre d'exemple, un
circuit intégré rapide sur arséniure de gallium peut
comporter environ 75 à 80 mésas dont les dimensions

10

varient selon le composant protégé entre 1,5 et 2 ou 3 microns de côté.

La présente invention n'est pas limitée aux modes de réalisation qui ont été explicitement décrits ci-dessus ; elle en inclut les diverses variantes et généralisations comprises dans le domaine des revendications ci-après.

11

REVENDICATIONS

1. Procédé d'isolement des interconnexions de circuits intégrés, dont les composants sont réalisés, dans une couche active, sur des ilôts dénommés "mésa", en relief par rapport au substrat qui supporte la couche active, caractérisé en ce que, pour chaque composant, il comporte la suite des opérations suivantes :

- le composant est protégé sur sa surface libre par un dépôt métallique, constitué par une ou plusieurs couches de métaux de nature différente, et délimité par photolithographie ou par la méthode de dépôt sur résine ;

- le mésa est creusé autour du composant, par usinage ionique ;

- le substrat et la couche active, sous le dépôt métallique, sont attaqués en pourtour du mésa, par voie chimique, de façon à créer une sous-gravure du dépôt métallique ;

- un diélectrique est déposé, par pulvérisation cathodique, à basse température, sur l'ensemble du circuit, le pourtour inférieur du dépôt métallique, sous-gravé au cours de l'opération précédente, étant épargné par cette méthode de pulvérisation ;

- le dépôt de diélectrique et le dépôt métallique, qui recouvrent chaque composant, sont éliminés par attaque chimique du métal, ladite attaque commençant par le pourtour du dépôt métallique laissé à nu, tandis que le dépôt de diélectrique sur le substrat demeure et protège les flancs du mésa.

2. Procédé d'isolement selon la revendication 1, caractérisé en ce que le dépôt métallique est constitué par une couche d'aluminium.

3. Procédé d'isolement selon la revendication 1, caractérisé en ce que le dépôt métallique est constitué par une couche d'aluminium, elle-même recouverte par une couche de chrome.

12

4. Procédé d'isolement selon la revendication 1, caractérisé en ce que les opérations d'usinage ionique et de sous-gravure par voie chimique, sont remplacées par une unique opération de creusement par voie chimique.

5. Procédé d'isolement selon la revendication 1, caractérisé en ce que, dans une variante du procédé, le dépôt métallique comporte une couche d'aluminium recouverte par une couche de chrome, et en ce que, après les opérations de creusement du mésa et de sous-gravure chimique, la couche d'aluminium est sous-gravée, sous la couche de chrome, par une attaque par voie chimique.

6. Procédé d'isolement selon l'une quelconque des revendications 1 ou 5, caractérisé en ce que la solution de sous-gravure chimique comporte une partie d'acide orthophosphorique $PO_4H_3$, une partie d'eau oxygénée $H_2O_2$ et 998 parties d'eau $H_2O$, en volume.

7. Procédé d'isolement selon l'une quelconque des revendications 1 ou 5, caractérisé en ce que, dans l'opération finale, le dépôt de diélectrique et le dépôt métallique qui recouvrent chaque composant sont éliminés par l'action combinée d'une solution d'acide chlorhydrique HCl, à 36-40 % et des ultra-sons.

8. Procédé d'isolement selon la revendication 1, caractérisé en ce que le diélectrique recouvre le substrat et les flancs du mésa, et affleure la surface libre du mésa sans la recouvrir.

9. Procédé d'isolement selon la revendication 5, caractérisé en ce que le diélectrique recouvre le substrat et les flancs du mésa, et recouvre partiellement la surface libre du mésa, sur son pourtour.

10. Circuit intégré semiconducteur, caractérisé en ce que les interconnexions déposées à sa surface sont isolées du substrat par le procédé d'isolement selon l'une quelconque des revendications 1 à 9.

# FIG.1

5
3
4
6        6        4
1        2

# FIG.2

8
7
1

# FIG.3

8
7
9
1

## FIG. 4

## FIG.5

## FIG.6

**FIG.7**

**FIG.8**

**FIG.9**